# EUROPÄISCHE PATENTANMELDUNG

(11) **EP 4 318 555 A1**
(43) Veröffentlichungstag der Anmeldung: **07.02.2024**
(21) Anmeldenummer: 22188860.5
(22) Anmeldetag: 04.08.2022
(51) Int. Cl.: H01L 21/603, H01L 23/488

(54) **VERFAHREN ZUM HERSTELLEN EINER KALTVERSCHWEISSTEN ELEKTRISCHEN VERBINDUNG ZWISCHEN EINEM SCHALTUNGSELEMENT UND EINEM WEITEREN ELEMENT MITTELS EINES PRESSWERKZEUGS MIT AUSFORMUNGEN**

(71) Anmelder: Siemens Aktiengesellschaft, 80333 München (DE)
(72) Erfinder: Stegmeier, Stefan, 81825 München (DE); Feil, Wolfgang, 92421 Schwandorf (DE); Lasch, Markus, 81927 München (DE); Schaller, Karl-Heinz, 92289 Ursensollen (DE); Schwarz, Markus, 80798 München (DE); Wöllmer, Heinz, 92260 Ammerthal (DE)
(74) Vertreter: Siemens Patent Attorneys

(57) **Zusammenfassung**

Die vorliegende Erfindung betrifft ein Verfahren zum Herstellen einer elektrischen Verbindung zwischen einem Schaltungselement (110, 210, 310) (z.B., einem Halbleiterelement wie einem Leistungshalbleiterbaustein) und einem weiteren Element (oder Leiter). Dabei wird zunächst jeweils ein elektrischer Kontakt (111, 211, 311, 120, 220, 320) mit einem flächigen Abschnitt (112, 212, 312, 122, 222, 322) an dem Schaltungselement (110, 210, 310) und an dem weiteren Element bereitgestellt. Zudem werden mehrere Zapfen (Pillars) (113, 213, 313) aus leitfähigem Material auf dem flächigen Abschnitt (112, 212, 312) eines der Kontakte (111, 211, 311) sowie korrespondierende Aussparungen (121, 221, 321) aus leitfähigem Material auf dem flächigen Abschnitt des anderen Kontaktes (120, 220, 320) bereitgestellt, wobei das leitfähige Material der Zapfen (113, 213, 313) und das leitfähige Material der Aussparungen (121, 221, 321) so gewählt werden, dass diese kaltverschweißbar sind, wobei die Aussparungen (121, 221, 321) als Durchgangsöffnungen bereitgestellt werden und wobei die Zapfen (113, 213, 313) so gebildet werden, dass sie nach einem vollständigen Einführen in die Durchgangsöffnungen (121, 221, 321) auf der anderen Seite der Durchgangsöffnungen (121, 221, 321) herausragen. Die Zapfen (113, 213, 313) werden in die Durchgangsöffnungen (121, 221, 321) eingeführt und miteinander kaltverschweißt durch zumindest teilweises Verpressen der Zapfen (113, 213, 313) in den Durchgangsöffnungen (121, 221, 321) mittels eines Presswerkzeugs (130, 230, 330), welches zumindest für ausgewählte der Zapfen (113, 213, 313) Ausformungen (131, 231, 331) aufweist, welche eine bezüglich einer Pressrichtung (132, 232, 332) seitliche Verformung (140A, 240A, 340A, 140B, 240B, 340B) der ausgewählten Zapfen (113, 213, 313) während des Pressvorgangs begünstigen und eine geringere Druckbeanspruchung des die Zapfen (113, 213, 313) tragenden Elements (110, 210, 310) bewirken. Da die Presskraft bereits zu Beginn des Pressvorgangs seitliche Komponenten aufweist, wird die Belastung in Richtung des Schaltungselements (110, 210, 310) vermieden bzw. verringert. Die Ausformungen (131, 231) können zumindest annäherungsweise auf die Querschnittsmittelpunkte der ausgewählten Zapfen (113, 213) wirken, wobei die Zapfen (213) zusätzlich hohl gebildet werden können, so dass die hohl gebildeten Zapfen (213) Sacklöcher aufweisen, die geringere Querschnittsdimensionen aufweisen als die Ausformungen (231) des Presswerkzeugs (230) und in die die Ausformungen (231) des Presswerkzeugs (230) zu Beginn des Pressvorgangs teilweise greifen. Alternativ können die Ausformungen (331) zwischen jeweils zwei der ausgewählten Zapfen (313) auf das Material des Kontakts (320) mit den Durchgangsöffnungen (321) wirken, wobei der Kontakt (320) mit den Durchgangsöffnungen (321) zusätzlich Materialausnehmungen (323) in den Bereichen zwischen den Durchgangsöffnungen (321) aufweisen kann, die auf der dem flächigen Abschnitt (322) abgewandten Seite des Kontakts (320) ausgebildet sind und auf die die Ausformungen (331) des Presswekzeugs (330) wirken. Die Zapfen (113, 213, 313) und die korrespondierenden Durchgangsöffnungen (121, 221, 321) können in einem Raster angeordnet werden, vorzugsweise in einem quadratischen Raster. Das Schaltungselement (110, 210, 310) kann in allen Ausführungsbeispielen an zwei gegenüberliegenden Seiten Zapfen (Pillars) (113, 213, 313) aufweisen, die in einem Arbeitsschritt durch beidseitige Verpressung der Pillars (113, 213, 313) in entsprechenden Öffnungen (121, 221, 321) von Kontakten (120, 220, 320) mit diesen elektrisch kontaktiert werden.

## Beschreibung

Die vorliegende Erfindung betrifft ein Verfahren zum Herstellen einer elektrischen Verbindung für eine neuartige Aufbau- und Verbindungstechnik, insbesondere für die Leistungselektronik.

Die Aufbau- und Verbindungstechnik hat die Aufgabe, elektrische und mechanische Verbindungen zwischen den einzelnen Elementen einer Schaltung und ggf. einem Schaltungsträger zu schaffen.

Insbesondere für Leistungshalbleiter hat es sich als vorteilhaft herausgestellt, diese mit Kontakten oder Kontaktflächen an mehreren Seiten auszustatten, beispielsweise leiterplattenseitigen Kontakten und oberseitigen Kontakten. Verschiedene Aufbau- und Verbindungstechniken sind bekannt und in der Publikation "Applikationshandbuch Leistungshalbleiter", Herausgeber Semikron International GmbH, 2. Auflage 2015, ISBN 978-3-938843-85-7, in Kapitel 2.5 ausführlich beschrieben.

Das dort beschriebene Drahtbonden an der Oberseite hat allerdings den Nachteil, dass während der Herstellung der Verbindung Kräfte aufgewendet werden, durch welche das Halbleiterbauelement beschädigt werden kann. Zudem können im Betrieb lokale Temperaturerhöhungen entstehen, denen durch die Verwendung von mehreren Bonddrähten und dem sogenannten Stitching nur bedingt entgegengewirkt werden kann. Die Kontaktierungspunkte sind unvermeidbar einer punktuellen thermischen Belastung ausgesetzt und auch die Bonddrähte erwärmen sich aufgrund des während des Betriebs durch sie fließenden Stroms und ihres durch das Bondverfahren begrenzten Querschnitts. Ferner können aufgrund von Induktion in den Bonddrähten unerwünschte elektrische Störsignale in die Schaltung eingebracht werden, insbesondere kann bei parallel verlaufenden Bonddrähten, die zu verschiedenen Kontakten führen, ein unerwünschtes Übersprechen auftreten.

Als Alternative zu Bonddrähten sind u.a. aus vorstehend genannter Publikation Sinterverfahren bekannt, die im Gegensatz zu den Bonddrähten flächige Verbindungen mit deutlich größeren Querschnitten erlauben und sowohl trägerseitig als auch oberseitig einsetzbar sind und sich gegenüber Lötverbindungen durch eine deutlich höhere Temperaturbeständigkeit auszeichnen. Nachteilig an diesen Sinterverfahren ist jedoch der hohe Fertigungsaufwand bei Bestückung der Leiterplatten bzw. Schaltungsträger und insbesondere der hohe Druck, der für den Sintervorgang erforderlich ist.

Schließlich sind u.a. ebenfalls aus der vorstehend genannten Publikation Druckkontaktierungen bekannt, die an die Stelle der vorgenannten stoffschlüssigen Verbindungsarten treten. Dabei gleiten die verbundenen Partner aufeinander und vermeiden damit thermische Spannungen, die bei den stoffschlüssigen Verbindungen im Betrieb zwangsläufig auftreten und z.B. mittels geeignet flexibler Materialien kompensiert werden müssen. Druckkontaktierungen haben allerdings den Nachteil, dass auf den Halbleiter dauerhaft Druck ausgeübt wird, der sich mit der Temperatur ändert und das Halbleiterbauelement im Laufe der Zeit beschädigen kann. Zudem erfordern flächige Kontaktierungen perfekt ebene Flächen und es muss sichergestellt werden, dass die aufeinander gleitenden Kontakte dauerhaft frei von Verschmutzungen und Oxidschichten bleiben.

Aus der WO 2021/013401 A1 sind formschlüssige Verbindungen zwischen einer Entwärmungskörperanordnung und einem Leistungshalbleiter bekannt, die durch eine Vielzahl stelenartiger Entwärmungskörper und dazu korrespondierenden Kavitäten gebildet werden, um die Oberfläche der Kontaktierung zu erhöhen und die Nachteile der Druckkontaktierungen zu vermeiden, indem nach erfolgter Montage keine Kräfte mehr auf die Oberfläche des Halbleiters wirken. Allerdings erfordert die Montage der Entwärmungskörperanordnung einen zusätzlichen Arbeitsschritt, nämlich das Verkleben oder Verlöten der Verbindung.

Aus der nach dem Anmeldedatum der vorliegenden Patentanmeldung veröffentlichten europäischen Patentanmeldung mit der Anmeldenummer 21169983.0 ist eine Aufbau- und Verbindungstechnik bekannt, bei der ein Halbleiter an zwei gegenüberliegenden Seiten jeweils einen Kontakt aufweist, bei dem aus jeweiligen Flächen Zapfen bzw. Pillars herausragen. Für die Verbindung mit den Kontakten vorgesehene Leiter weisen passende Öffnungen zur Aufnahme der Zapfen bzw. Pillars auf und sind mit diesen kaltverschweißbar. Dabei sind die Zapfen etwas länger als die Ausdehnung der Leiter in Richtung der Öffnungen, weswegen die Zapfen aus den durchgehenden Öffnungen herausragen, nachdem sie vollständig bzw. bis zur vorgesehenen Montageposition in die Öffnungen eingeführt wurden.

Die Zapfen bzw. Pillars werden mit den Leitern kaltverschweißt, indem flächig Druck auf die Zapfenenden ausgeübt wird, beispielsweise durch die Backen einer Presse, und die Zapfen dabei in den Öffnungen verpresst und dabei kaltverschweißt werden. Dabei kann der Überstand der Zapfen so gewählt werden, dass auch nach der Verpressung der Zapfen in den Öffnungen ein Teil der Zapfen übersteht und diese zu Stülpungen bzw. einer Art Nietköpfen verformt werden, die flächig an den Leitern anliegen und damit zusätzliche Kontaktfläche liefern und den Übergangswiderstand zwischen dem Halbleiter und dem Leiter weiter verringern. Außerdem wird die Verbindung zwischen dem Halbleiter und den Leitern auf diese Weise zusätzlich mechanisch gegen Lösen gesichert.

Nachteilig an diesem Herstellungsverfahren ist, dass die auf die Zapfen bzw. Pillars wirkenden Kräfte zu Rissbildungen an den Halbleitern führen können.

Eine Aufgabe der vorliegenden Erfindung ist es, eine verbessertes Herstellungsverfahren für diese besondere Aufbau- und Verbindungstechnik anzugeben.

Diese Aufgabe wird durch ein Verfahren mit den Merkmalen des Patentanspruchs 1 gelöst. Insbesondere wird der Pressvorgang mit einem besonders geformten Presswerkzeug durchgeführt. Erfindungsgemäß wird ein Presswerkzeug verwendet, welches zumindest für ausgewählte der Zapfen bzw. Pillars Ausformungen aufweist, die beispielsweise aus einem Presswerkzeug mit im Wesentlichen planer Pressfläche herausragen. Die Ausformungen begünstigen eine bezüglich einer Pressrichtung seitliche Verformung der ausgewählten Zapfen während des Pressvorgangs und bewirken somit eine geringere Druckbeanspruchung des die Zapfen bzw. Pillars tragenden Elements.

Für im wesentlichen zylindrische Zapfen bzw. Pillars oder auch für Zapfen bzw. Pillars mit in wesentlichem quadratischem Querschnitt können die Ausformungen dabei beispielsweise halbkugelförmig auf einer im Übrigen planen Pressbacke ausgebildet sein, oder in Form eines halbkugelförmigen Abschlusses einer zylindrischen Ausformung auf einer im Übrigen planen Pressbacke ausgebildet sein. Ebenso ist es möglich, pyramidenförmige Ausformungen oder pyramidenförmige Abschlüsse von Ausformungen einzusetzen, wobei Pyramiden mit kreisförmiger Grundfläche bevorzugt sind, aber auch Pyramiden mit n-eckiger Grundfläche, insbesondere n=3, n=4 oder n=6, auf entsprechend geformten Ausformungen auf einer Pressbacke.

Da die Presskraft bereits zu Beginn des Pressvorgangs seitliche Komponenten aufweist, wird die Belastung in Richtung des Halbleiters vermieden bzw. verringert.

Die Anwendung des vorliegenden Verfahrens ist sowohl bei einseitig an einem Element angebrachten Zapfen bzw. Pillars anwendbar als auch bei auf gegenüberliegenden Seiten des Elements angebrachten Zapfen bzw. Pillars zur gleichzeitigen Herstellung zweiter Kontaktierungen, wie beispielsweise in der bereits erwähnten europäischen Patentanmeldung mit der Anmeldenummer 21169983.0 gezeigt.

Im folgenden werden Ausführungsbeispiele der vorliegenden Erfindung anhand von Zeichnungen näher erläutert.

Es zeigen:
Fig. 1 in schematischer Darstellung die wesentlichen Schritte eines ersten Ausführungsbeispiels des erfindungsgemäßen Verfahrens;
Fig. 2 in schematischer Darstellung die wesentlichen Schritte eines zweiten Ausführungsbeispiels des erfindungsgemäßen Verfahrens; und
Fig. 3 in schematischer Darstellung die wesentlichen Schritte eines dritten Ausführungsbeispiels des erfindungsgemäßen Verfahrens.

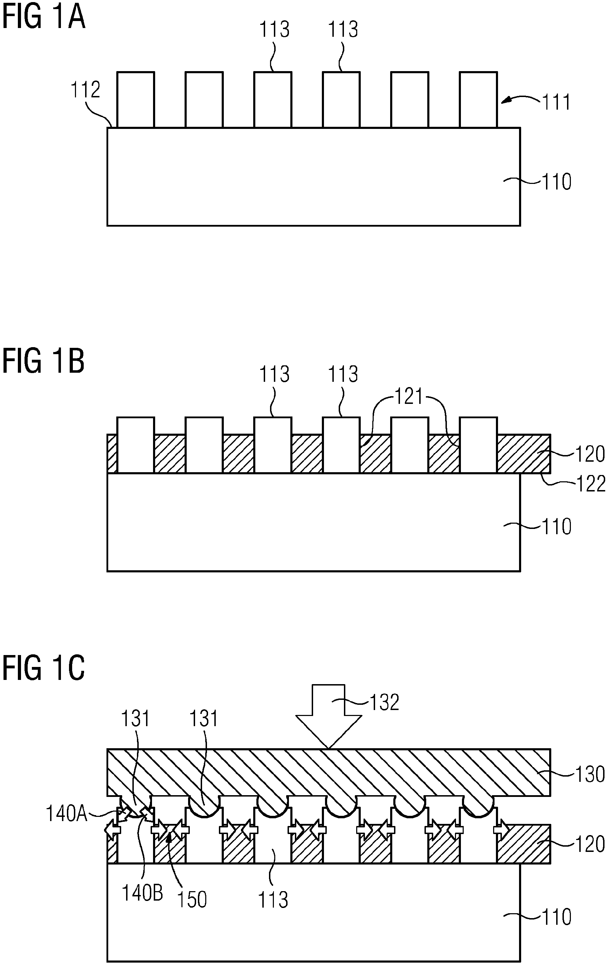

Fig. 1A zeigt in schematischer Darstellung einen Leistungshalbleiterbaustein 110. Dabei kann der Leistungshalbleiterbaustein 110 bereits mit dem hier beschriebenen Verfahren oder einem herkömmlichen Verfahren, beispielsweise durch Auflöten oder durch Sinterverfahren mit einem anderen Element oder einem Träger (nicht dargestellt) kontaktiert sein.

Der Halbleiter 110 weist an ein einer Seite, in der Darstellung der Fig. 1 oben, einen Kontakt 111 auf, bei dem aus einer Fläche 112 Zapfen bzw. Pillars 113 herausragen. In Ausgestaltungen der vorliegenden Erfindungen kann der Halbleiter 110 auch ein der gegenüberliegenden Seite, in der Darstellung der Fig. 1 unten, einen solchen Kontakt mit entsprechenden Pillars aufweisen (nicht dargestellt). Die Zapfen können dabei im wesentlichen zylindrisch oder mit quadratischem Querschnitt ausgebildet sein. Denkbar sind auch Zapfen mit einseitig offenem Profil wie beispielsweise Zapfen mit U-förmigem Querschnitt.

Fig. 1B zeigt den Halbleiter aus Fig. 1A, dessen Zapfen bzw. Pillars 113 bereits in Durchgangsöffnungen 121 eines Kontakts 120 eines anderen Elements oder Leiters (nicht dargestellt) eingeführt sind. Dabei ist der Kontakt 120 in schematischer Schnittdarstellung gezeigt, wobei der Schnitt entlang mehrerer in einer Reihe angeordneter Öffnungen 121 erfolgte.

Die Öffnungen 121 und Zapfen bzw. Pillars 113 sind so geformt und das Material für die Zapfen 113 einerseits und den Kontakt 120 andererseits wird so gewählt, dass die Zapfen in den Öffnungen mit dem Kontakt kaltverschweißbar sind. Dabei sind die Zapfen, wie in Fig. 1A gezeigt, vorzugsweise etwas länger als die Ausdehnung des Leiters 120 in Richtung der Öffnungen, weswegen die Zapfen 113 aus den durchgehenden Öffnungen 121 herausragen, nachdem sie vollständig bzw. bis zur vorgesehenen Montageposition in die Öffnungen eingeführt wurden. Die Zapfen 113 können sich dabei noch vorteilhaft auf einer metallischen Bufferschicht (in Fig. 1 nicht dargestellt) befinden, welche wiederum auf dem Halbleiter 110 aufgebracht wird. Die Bufferschicht hat dabei die Aufgabe, bei dem hier beschriebenen Fügeprozess eine bessere Druck- bzw. Kraftverteilung zu bewirken und somit das Risiko einer Beschädigung des Halbleiters zu reduzieren.

Die Kaltverschweißung 150 wird erreicht, indem wie in Fig. 1C dargestellt Druck 132 auf die Zapfenenden ausgeübt wird. Dabei wird ein Presswerkzeug 130 verwendet, welches Ausformungen bzw. Strukturen 131 auf der Arbeitsfläche (in Fig. 1C die untere Fläche des Presswerkzeugs 130) aufweist, welche Winkel oder Rundungen aufweisen und die mittig bzw. zentrisch auf die Zapfen bzw. Pillars 113 wirken. Diese Anordnung der Ausformungen 131 bezüglich der Pillars 113 sowie die Winkel oder Rundungen an den zapfenseitigen Enden der Ausformungen 131 bewirken eine Kraftwirkung auf die Pillars, die nicht ausschließlich in Längsrichtung der Pillars 113 und damit auf den Halbleiter und die Verbindungsstelle zwischen Halbleiter und Pillar wirkt, sondern auch von der Hauptkraftrichtung 132 abweichende Komponenten aufweist, angedeutet durch Pfeile 140A und 140B. Dadurch wird einerseits der Halbleiter entlastet und Beschädigungen, insbesondere Rissbildungen, des Halbleiters werden vermieden. Andererseits wird die Verschweißung 150 begünstigt, also die Verpressung der Zapfen in den Öffnungen und dabei Herstellung der Kaltverschweißung (Formschluss und Kaltverschweißung angedeutet durch die kleinen Pfeile 150 in horizontaler Richtung). Der Überstand der Zapfen kann dabei so gewählt werden, dass die Zapfen nach Verbindung bündig mit dem Kontakt 120 abschließen oder dass auch nach der Verpressung der Zapfen in den Öffnungen ein Teil der Zapfen übersteht und diese Teile zu einer Stülpung bzw. einer Art Nietkopf verformt werden (nicht dargestellt), die eine zusätzliche Kontaktfläche liefern und den Übergangswiderstand zwischen Halbleiter 110 und Kontakt 120 weiter verringern. Außerdem wird die Verbindung zwischen den Kontakten 111 und 120 auf diese Weise zusätzlich mechanisch gegen Lösen gesichert.

Um die Kaltverschweißung zu begünstigen, können die Zapfen und/oder die korrespondierenden Durchgangsöffnungen eine entsprechende Beschichtung aufweisen. Die bereits erwähnte Bufferschicht kann in Ausführungsbeispielen diese Aufgabe mit übernehmen. Insbesondere eignen sich Beschichtungen aufweisend einen der folgenden Stoffe: Zinn, CuCrAg, CuNiSi oder CuSn.

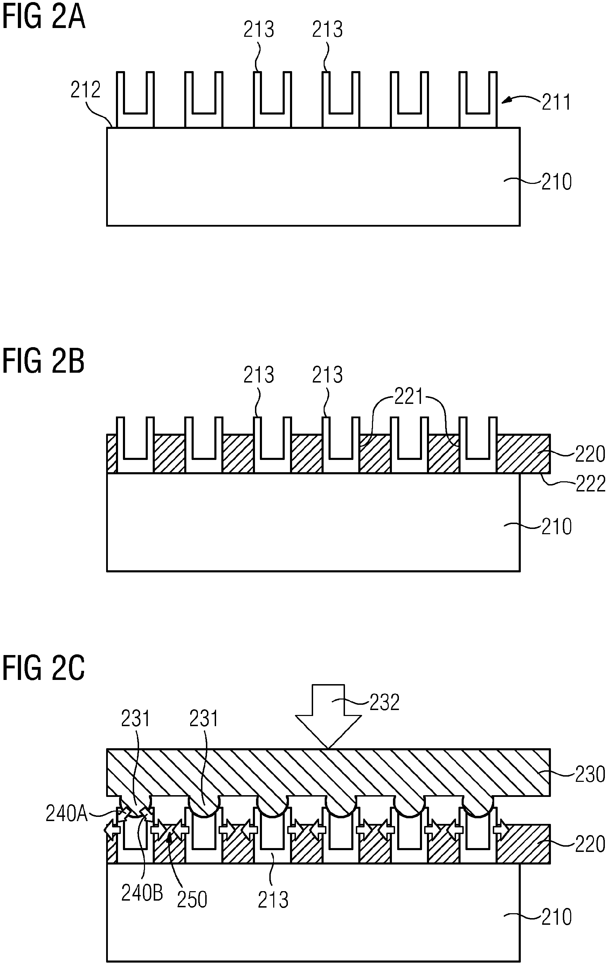

Fig. 2 zeigt die wesentlichen Schritte eines zweiten Ausführungsbeispiels des erfindungsgemäßen Verfahrens in schematischer Darstellung, wobei zur Vermeidung von Wiederholungen im Folgenden nur die Unterschiede gegenüber dem im Fig. 1 dargestellten Ausführungsbeispiel erläutert werden.

Fig. 2 zeigt insbesondere, dass die Zapfen bzw. Pillars 213 hohl ausgestaltet sind, also beispielsweise Bohrungen oder Sacklöcher aufweisen. Diese Bohrungen oder Sacklöcher weisen geringere Querschnittsdimensionen auf als die Ausformungen 231 des Presswerkzeugs 230, also beispielsweise einen geringeren Durchmesser bei hohlzylinderförmigen Pillars 213. Die Ausformungen 231 des Presswerkzeugs greifen zu Beginn des Pressvorgangs vorzugsweise teilweise in die Sacklöcher der Pillars sein und die seitliche Kräfteverteilung sowie die Aufweitung der Pillars wird auf diese Weise stärker begünstigt als im Ausführungsbeispiel der Fig. 1. Dadurch wird der Halbleiter in noch stärkerem Maße entlastet und Beschädigungen, insbesondere Rissbildungen, des Halbleiters werden besser vermieden.

Andererseits wird die Verschweißung 250 begünstigt und insbesondere die Ausformung der Stülpung.

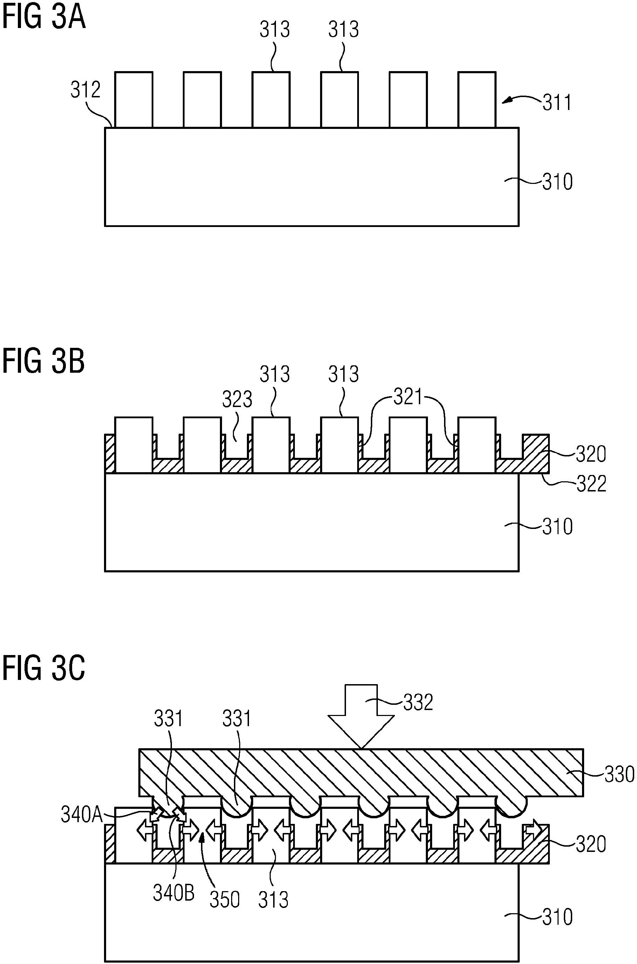

Fig. 3 zeigt die wesentlichen Schritte eines dritten Ausführungsbeispiels des erfindungsgemäßen Verfahrens in schematischer Darstellung, wobei zur Vermeidung von Wiederholungen im Folgenden nur die Unterschiede gegenüber dem im Fig. 1 dargestellten Ausführungsbeispiel erläutert werden.

Fig. 3 zeigt insbesondere, dass die Ausformungen 331 des Presswerkzeugs 330 nicht auf die Enden der Zapfen bzw. Pillars 313 wirken, sondern in den Zwischenräumen zwischen den Pillars 313 auf das Material des Kontakts 320.

Der Kontakt 320 kann dafür zwischen den Durchgangsöffnungen 321 noch Bohrungen bzw. Sacklöcher 323 aufweisen, um die Verformung in der gewünschten Richtung zu begünstigen.

Die Ausgestaltung gemäß Fig. 3 hat gegenüber dem Ausführungsbeispiel gemäß Fig. 2 insbesondere den Vorteil, dass zur Vorbereitung der Kontaktierung nicht die Zapfen bzw. Pillars bearbeitet werden müssen, was aufwendig ist und zu einer Beanspruchung des Halbleiters 210 sowie der Verbindung zwischen Pillars 213 und Halbleiter 210 führen kann, sondern es genügt, den Kontakt bzw. Leadframe 320 zu bearbeiten, was zudem kostengünstig durch Walzprägen oder ähnliche Verfahren erfolgen kann.

Die Dimension der Ausformungen 331 des Presswerkzeugs in Relation zu Dimension und Anordnung der Pillars 313 und Durchgangsöffnungen 321 sowie der Dimension der Sacklöcher 323 wird so gewählt, dass eine für die Kaltverschweißung ausreichende Materialverdrängung erreicht wird.

Nicht figürlich dargestellt ist, dass der Halbleiter natürlich in allen Ausführungsbeispielen an zwei gegenüberliegenden Seiten Pillars aufweisen kann, die in einem Arbeitsschritt durch beidseitige Verpressung der Pillars in entsprechenden Öffnungen von Kontakten mit diesen elektrisch kontaktiert werden.

Es sei darauf hingewiesen, dass sich die im Zusammenhang mit den Fig. 1 bis 3 beschriebenen Methoden kombinieren lassen, und zwar einerseits auf verschiedenen Seiten des Halbleiters, andererseits aber auch auf der gleichen Seite, indem beispielsweise Pillars aus Vollmaterial gemäß Fig. 1 und Pillars mit Sacklöchern gemäß Fig. 2 miteinander kombiniert werden, beispielsweise um die mechanische Beanspruchbarkeit der Kontaktierung zu verbessern.

Es sei darauf hingewiesen, dass in den Darstellungen und im vorstehenden Text die Begriffe bzw. die räumliche Orientierung "oben", "unten", "horizontal", "vertikal" nicht einschränkend zu verstehen ist

Ferner sei darauf hingewiesen, dass die Ausführungsbeispiele der vorliegenden Erfindung auf Leistungshalbleiter Bezug nehmen, weil dort die zuverlässige, möglichst großflächige, möglichst chipnahe und deswegen möglichst ohne Zuführung von Wärme durchgeführte Kontaktierung von besonderer Bedeutung ist. Die Erfindung ist aber natürlich nicht auf Leistungshalbleiter beschränkt, sondern im Zusammenhang mit allen auf Schaltungsträgern montierbaren Bauelementen, aktiv oder passiv, einsetzbar.

## Patentansprüche

1. Verfahren zum Herstellen einer elektrisch leitfähigen Verbindung zwischen einem Schaltungselement (110, 210, 310) und einem weiteren Element, mit folgenden Schritten:
- Bereitstellen jeweils eines elektrischen Kontakts (111, 211, 311, 120, 220, 320) mit einem flächigen Abschnitt (112, 212, 312, 122, 222, 322) an dem Schaltungselement und an dem weiteren Element;
- Bereitstellen mehrerer Zapfen (113, 213, 313) aus leitfähigem Material auf dem flächigen Abschnitt (112, 212, 312) eines der Kontakte (111, 211, 311) sowie Bereitstellen korrespondierender Aussparungen (121, 221, 321) aus leitfähigem Material auf dem flächigen Abschnitt des anderen Kontaktes (120, 220, 320), wobei
- das leitfähige Material der Zapfen und das leitfähige Material der Aussparungen so gewählt werden, dass diese kaltverschweißbar sind und wobei
- die Aussparungen als Durchgangsöffnungen (121, 221, 321) bereitgestellt werden und wobei
- die Zapfen (111, 211, 311) so gebildet werden, dass sie nach einem vollständigen Einführen in die Durchgangsöffnungen auf der anderen Seite der Durchgangsöffnungen herausragen;
- Einführen der Zapfen in die Aussparungen;
- Kaltverschweißen der Zapfen mit den Aussparungen durch zumindest teilweises Verpressen der Zapfen in den Durchgangsöffnungen mittels eines Presswerkzeugs (130, 230, 330), welches zumindest für ausgewählte der Zapfen Ausformungen (131, 231, 331) aufweist, welche eine bezüglich einer Pressrichtung (132, 232, 332) seitliche Verformung (140A, 240A, 340A, 140B, 240B, 340B) der ausgewählten Zapfen während des Pressvorgangs begünstigen und eine geringere Druckbeanspruchung des die Zapfen tragenden Elements bewirken.

2. Verfahren nach Anspruch 1, bei dem die Ausformungen (131, 231) zumindest annäherungsweise auf die Querschnittsmittelpunkte der ausgewählten Zapfen (113, 213) wirken.

3. Verfahren nach Anspruch 1, bei dem die Ausformungen (331) zwischen jeweils zwei der ausgewählten Zapfen (313) wirken.

4. Verfahren nach einem der vorhergehenden Ansprüche, bei dem die Zapfen (213) hohl gebildet werden.

5. Verfahren nach einem der vorhergehenden Ansprüche, bei dem der Kontakt (320) mit den Durchgangsöffnungen (321) zusätzlich Materialausnehmungen (323) in den Bereichen zwischen den Durchgangsöffnungen aufweist, die auf der dem flächigen Abschnitt (322) abgewandten Seite des Kontakts ausgebildet sind.

6. Verfahren nach einem der vorhergehenden Ansprüche, bei dem die Zapfen und die korrespondierenden Durchgangsöffnungen in einem Raster angeordnet werden, vorzugsweise in einem quadratischen Raster.

7. Verfahren nach einem der vorhergehenden Ansprüche, bei dem die Zapfen und/oder die korrespondierenden Durchgangsöffnungen eine Beschichtung aufweisen, welche eine Kaltverschweißung begünstigen.

8. Verfahren nach Anspruch 7, bei dem die Beschichtung einen der folgenden Stoffe aufweist: Zinn, CuCrAg, CuNiSi oder CuSn.
